# EUROPEAN PATENT APPLICATION

(11) **EP 4 822 382 A1**
(43) Date of publication of application: **14.10.2026**
(21) Application number: 24935586.8
(22) Date of filing: 02.08.2024
(51) Int. Cl.: G01R 35/02, H02G 3/08

(54) **LIVE DETECTION SYSTEM FOR IN-OPERATION LOW-VOLTAGE CURRENT TRANSFORMER, AND WIRING CONNECTION APPARATUS**

(30) Priority: 18.04.2024 CN 202410466783
(71) Applicant: Yunnan Power Grid Co., Ltd., Kunming, Yunnan 650000 (CN); Yunnan Electric Power Test and Research Institute (Group) Co., Ltd., Kunming, Yunnan 650206 (CN)
(72) Inventor: LIU, Qingchan, Kunming, Yunnan 650000 (CN); LI, Tengbin, Kunming, Yunnan 650000 (CN); LIN, Cong, Kunming, Yunnan 650000 (CN); QI, Jiaqi, Kunming, Yunnan 650000 (CN); YIN, Yujun, Kunming, Yunnan 650000 (CN); CHANG, Junchao, Kunming, Yunnan 650000 (CN); ZHONG, Yao, Kunming, Yunnan 650000 (CN); TIAN, Qingsheng, Kunming, Yunnan 650000 (CN)
(74) Representative: Osterhoff, Utz
(86) International application number: PCT/CN2024/109589
(87) International publication number: WO 2025/218054

(57) **Abstract**

A live detection system for an in-operation low-voltage current transformer, including a primary standard current transformer, a primary current collection circuit, a secondary standard current transformer, a secondary current collection circuit, an isolated data conversion module, a programmable power supply, a programmable controller, a human-machine interaction unit and a microprocessor, which are capable of adjusting the current value of the test primary current flowing through the low-voltage current transformer and the standard current transformer to obtain a continuously adjustable test current for full-range verification; a wiring connection apparatus is also disclosed, capable of realizing fast wiring and ensuring that the force and degree of each wiring are maintained at the optimal effect without too tight or too loose connection.

## Description

### TECHNICAL FIELD

The present application relates to the technical field of power system monitoring, in particular to a live detection system for an in-operation low-voltage current transformer, and a wiring connection apparatus.

### BACKGROUND

There is a strong demand for live detection technology that can continuously or periodically monitor the condition of equipment without affecting equipment operation. For current transformers, mature technologies include dissolved gas-in-oil analysis, partial discharge detection, dielectric loss and capacitance measurement, etc. However, these are all items for detecting insulation conditions, and there is no live detection method for the errors of current transformers. The errors of current transformers directly affect the the metering of electricity and the reliability of relay protection. Long-term inaccurate metering and misoperation of relay protection will cause huge economic losses to power supply enterprises or power consumption enterprises, and may even lead to damage to power equipment and large-scale power outages of the power grid.

Existing current transformers typically have secondary windings encased around the primary winding, including several measuring windings and protection windings. The outgoing lines of each secondary winding are connected to a three-phase common terminal box provided near the current transformer, and then connected to distant loads through wires. Usually, when detecting the error of a current transformer, the current transformer must be powered off, the original circuit is disconnected from the terminals S1, S2, S3, S4 of each secondary winding, and temporary leads are connected to a transformer calibrator. The secondary leads of an external standard current transformer are also connected to the movable transformer calibrator at the same time, and the errors of each winding of the current transformer are obtained after comparison.

According to JJG1189.3-2022 Measuring Transformers Part 3: Power Current Transformers, when testing current transformers, the verification points are 1%, 5%, 20%, 100% and 120% of the rated current. When testing under power failure conditions, the current can be linearly adjusted to the corresponding test current point using the power frequency voltage regulator and the boost current power supply. However, the testing is conducted under energized conditions. Since the transformer is in operation and under load, the line itself has a real current, which is closely related to the current electrical load. During energized testing, to meet the required current point, the device needs to provide an adjustable current range of 1% to 120% of the rated current to achieve error testing under full current.

### SUMMARY

In view of the above problems existing in the prior art, the present application is proposed.

Therefore, the problem to be solved by the present application is how to adjust the current value of the test primary current flowing through the low-voltage current transformer and the standard current transformer, so as to obtain a continuously adjustable test current of % to % and realize full-range verification.

In order to solve the above technical problems, the present application provides the following technical solution: a live detection system for an in-operation low-voltage current transformer.

As a preferred embodiment of the live detection system for the in-operation low-voltage current transformer according to the present application, where: the primary standard current transformer is connected to primary current data collection, one end of the primary standard current transformer is connected to a primary current line, and the other end of the primary standard current transformer is located at an interface of a primary current collection circuit;
the primary current collection circuit converts a circuit signal input by the primary standard current transformer into a voltage signal;
the secondary standard current transformer is connected to secondary current data collection of a transformer under test, one end of the secondary standard current transformer is connected to a secondary current line of the transformer under test, and the other end of the secondary standard current transformer is connected to an interface of a secondary current collection circuit;
the secondary current collection circuit converts a current signal input by the secondary standard current transformer into a voltage signal;
the isolated data conversion module is electrically connected to outputs of the primary current collection circuit and the secondary current collection circuit to isolate and convert an input signal;
the programmable controller is electrically connected to the isolated data conversion module and capable of controlling different mode states and data communication of the system; and
the microprocessor is configured for performing digital signal processing and analysis, performing error analysis, discrete Fourier transform processing, electric energy conversion for sampled data of different channels, and finally obtaining test results;
an input end of a programmable power supply is connected to a mains power supply, and an output end of the programmable power supply is connected to the primary standard current transformer; a voltage transformer is installed at the output end of the programmable power supply, and after filtering and amplification, is sent to the isolated data conversion module for analog-to-digital (AD) conversion; and a drive protection module of the programmable power supply is electrically connected to the programmable controller.

As a preferred embodiment of the live detection system for the in-operation low-voltage current transformer according to the present application, the primary standard current transformer and the secondary standard current transformer include three windings: an input winding, an output winding and a feedback winding.

As a preferred embodiment of the live detection system for the in-operation low-voltage current transformer according to the present application, the programmable power supply mainly includes an electromagnetic interference (EMI) circuit, a rectifier circuit, a direct current intermediate circuit, an inverter circuit, a filter circuit, a voltage detection circuit and a drive protection circuit.

The present application also solves the problem that when connecting wiring terminals, the connection is occasionally too tight or too loose, resulting in damage to the connected wires or poor contact, poor connection effect and possible falling off. Therefore, a wiring connection apparatus that can realize fast wiring and ensure that the force and degree of each wiring connection reach the optimal effect is needed.

In order to solve the above technical problems, the present application also provides the following technical solution: a wiring connection apparatus, including a fixed assembly, a movable assembly and an adjusting assembly,

As a preferred embodiment of the wiring connection apparatus according to the present application, where: a fixed assembly includes a wiring box and a wiring screw, and the wiring screw is provided inside the wiring box;
a movable assembly provided at a top of the fixed assembly, and includes a translation plate, a movable frame and a positioning piece; the translation plate is provided at a top of the wiring box; the movable frame is provided at both ends of the translation plate, and the positioning piece is provided at an end of the movable frame; and
an adjusting assembly is provided inside the movable assembly, and includes an adjustment oblong tube, a rotating column, a reset column and an anti-tightening ring; the adjustment oblong tube passes through and is connected to the translation plate, and the rotating column is provided at a bottom of the adjustment oblong tube; the reset column is provided at a top of the adjustment oblong tube, and the anti-tightening ring is sleeved on an outside of the adjustment oblong tube.

As a preferred embodiment of the wiring connection apparatus according to the present application, the wiring box is provided with a wire hole and a screw hole, and the wire hole is provided at a bottom of a side surface of the wiring box; and the screw hole is provided at a top of the wire hole and in communication with a bottom surface of the wiring box, and the wiring screw is engaged with the screw hole.

As a preferred embodiment of the wiring connection apparatus according to the present application, the wiring box is further provided with a limiting horizontal groove and a positioning vertical groove, and the limiting horizontal groove is provided at a top of the side surface of the wiring box; and the positioning vertical groove is provided above and below the limiting horizontal groove, and the positioning vertical groove is directly opposite to the wire hole.

As a preferred embodiment of the wiring connection apparatus according to the present application, both sides of a bottom of the translation plate are engaged with the top of the wiring box; the translation plate is provided with a limiting horizontal hole and a limiting vertical hole; the limiting horizontal hole penetrates through a side surface of the translation plate, and the limiting horizontal hole is engaged with the anti-tightening ring; and the limiting vertical hole penetrates through an upper surface and a lower surface of the translation plate, and the limiting vertical hole is engaged with the adjustment oblong tube.

As a preferred embodiment of the wiring connection apparatus according to the present application, the movable frame is a half-frame; one end of a top of the movable frame is fixedly connected to the side surface of the translation plate, and one end of a bottom of the movable frame is provided with a limiting column; the limiting column is engaged with the limiting horizontal groove; a middle section of the limiting column is provided with a positioning groove, and the positioning piece is engaged with the positioning groove; the positioning piece is provided with a positioning spring and a positioning cone; one end of the positioning spring is fixed at a bottom of the positioning groove, and the other end of the positioning spring is fixed at a bottom of the positioning cone; and one end of the positioning cone is engaged with the positioning groove, and the other end of the positioning cone is engaged with the positioning vertical groove.

As a preferred embodiment of the wiring connection apparatus according to the present application, the adjustment oblong tube is provided with a double-thread thread and an external thread; the double-thread thread is provided inside the adjustment oblong tube; the external thread is provided at an outside of the adjustment oblong tube, and the adjustment oblong tube is engaged with the limiting vertical hole;
the rotating column is provided with positioning columns, a magnetic head and a mounting hole; the positioning columns are symmetrically provided at a side surface of the rotating column, and the positioning columns are engaged with the double-thread thread; the magnetic head is provided at a bottom of the rotating column; the magnetic head is fitted with the wiring screw, and the mounting hole is provided at a top of the rotating column.

As a preferred embodiment of the wiring connection apparatus according to the present application, the reset column is provided with a mounting column, a reset spring and a pressing table; the mounting column is provided at a bottom of the reset column, and the mounting column is rotatably connected with the mounting hole; the pressing table is provided at a top of the reset column, and the reset spring is sleeved on the top of the reset column; a top of the reset spring is fixedly connected to a bottom of the pressing table, and a bottom of the reset spring is fixedly connected to a top of the adjustment oblong tube; and an inner wall of the anti-tightening ring is provided with an internal thread; the internal thread is engaged with the external thread, and the anti-tightening ring is fitted with the limiting horizontal hole.

The beneficial effects of this invention are as follows: the apparatus uses a programmable power supply, which can realize precision self-calibration for the clamp meter in the live detection apparatus. This module can output a current signal of a certain magnitude, and the clamp meter can be embedded in the output coupling coil of this module to realize accurate calibration of the clamp meter. The human-machine interface is used for result display and user operation, and its interface system is installed with a test program, which is convenient for users to use and observe results.

At the same time, the voltage signal generated by the programmable power supply passes through the current booster to generate an adjusting current meeting the test requirements. The adjusting current is connected in series to the low-voltage current transformer and the standard current transformer, so as to adjust the current value of the test primary current flowing through the low-voltage current transformer and the standard current transformer, obtain a continuously adjustable test current of % to %, and realize full-range verification.

The present application can also realize fast wiring and ensure that the force and degree of each wiring are maintained at the optimal effect without too tight or too loose connection.

### BRIEF DESCRIPTION OF THE DRAWINGS

In order to illustrate the technical solutions in the embodiments of the present application or in the related art more clearly, the following briefly introduces the accompanying drawings required for the description of the embodiments or the related art. Obviously, the drawings in the following description are only part of embodiments of the present application. For those skilled in the art, other drawings can also be obtained according to the structures shown in these drawings without any creative effort.
FIG. 1 is a structural diagram of a full-range live detection system for an in-operation low-voltage current transformer.
FIG. 2 is an overall structural diagram of a wiring connection apparatus.
FIG. 3 is a structural diagram of a movable assembly of the wiring connection apparatus.
FIG. 4 is a structural diagram of an adjusting assembly of the wiring connection apparatus.
FIG. 5 is a sectional view of an adjustment oblong tube of the wiring connection apparatus.

### DETAILED DESCRIPTION OF THE EMBODIMENTS

In order to make the above objects, features and advantages of the present application more comprehensible, the specific embodiments of the present application will be described in detail below with reference to the accompanying drawings.

Many specific details are set forth in the following description to facilitate a full understanding of the present application However, the present application can also be implemented in other ways different from those described herein. Those skilled in the art can make similar promotion without violating the connotation of the present application, so the present application is not limited by the specific embodiments disclosed below.

Secondly, the term "an embodiment" or "embodiment" as used herein refers to a specific feature, structure, or characteristic that may be included in at least one implementation of the present application. The phrase "in one embodiment" appearing in different places in the specification does not necessarily refer to the same embodiment, nor is it a single embodiment or an embodiment selectively excluded from other embodiments.

### Embodiment 1

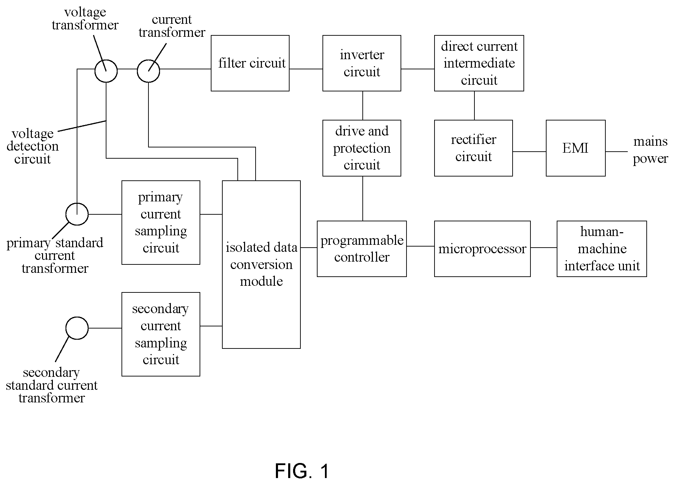

Referring to FIG. 1, it is the first embodiment of the present application, which provides a live detection system for an in-operation low-voltage current transformer, including: a primary standard current transformer, a primary current collection circuit, a secondary standard current transformer, a secondary current collection circuit, an isolated data conversion module, a programmable controller, a microprocessor, and a programmable power supply.

Specifically, the primary standard current transformer is connected to primary current data collection; one end of the primary standard current transformer is connected to the primary current line, and the other end of the primary standard current transformer is located at the interface of the primary current collection circuit.

The primary current collection circuit converts the circuit signal input by the primary standard current transformer into a voltage signal.

The secondary standard current transformer is connected to the secondary current data collection of the transformer under test; one end of the secondary standard current transformer is connected to the secondary current line of the transformer under test, and the other end of the secondary standard current transformer is connected to the interface of the secondary current collection circuit.

The secondary current collection circuit converts the current signal input by the secondary standard current transformer into a voltage signal.

The isolated data conversion module is electrically connected to the outputs of the primary current collection circuit and the secondary current collection circuit, and isolates and converts the input signals.

The programmable controller is electrically connected to the isolated data conversion module and is capable of controlling different mode states and data communication of the system.

The programmable controller is the control core of the device.

The microprocessor performs digital signal processing and analysis, performing error analysis, discrete Fourier transform processing, and power conversion on sampled data from different channels, ultimately obtaining the test results.

The microprocessor is the core operation unit of the apparatus.

The input end of a programmable power supply is connected to the mains power, the output end of the programmable power supply is connected to the primary standard current transformer. A voltage transformer is installed at the output end of the programmable power supply, and after filtering and amplification, is sent to the isolated data conversion module for analog-to-digital (AD) conversion; and a drive protection module of the programmable power supply is electrically connected to the programmable controller. The drive and protection module of the programmable power supply is electrically connected to the programmable controller.

Specifically, the primary standard current transformer and the secondary standard current transformer each include three windings: an input winding, an output winding and a feedback winding.

Specifically, the programmable power supply mainly includes an EMI circuit, a rectifier circuit, a direct current intermediate circuit, an inverter circuit, a filter circuit, a voltage detection circuit and a drive protection circuit.

The electromagnetic interference (EMI) power filter is a low-pass filter composed of inductors and capacitors, which allows direct current or powerfrequency signals to pass through and attenuates other high-frequency signals greatly. The rectifier circuit adopts an integrated chip with high reverse voltage resistance and stable operation. The intermediate direct current circuit adopts capacitor filtering and high-performance electrolytic capacitors. The inverter circuit adopts a bridge inverter circuit and insulated gate bipolar transistor (IGBT) as power switching tubes. The output filter circuit adopts an inductancecapacitance (LC) filter. The voltage detection circuit is equipped with a voltage transformer at the output end of the phase-shift circuit, which is filtered, amplified and sent to the isolated data conversion module for AD conversion, and then the current output voltage value and phase value can be known through the operation of the programmable controller. The drive protection circuit is equipped with a current transformer at the output end of the filter circuit, and a voltage proportional to the primary current to be detected can be obtained at the secondary side of the current transformer. The secondary voltage is proportional to the output current, and the secondary voltage is transmitted to the isolated data conversion module to be compared with the threshold voltage of the output current. When the secondary voltage exceeds the threshold voltage, the comparator outputs a high level, the corresponding pin of the programmable controller is at a low level, and the drive protection circuit is started to output an overcurrent protection program and turn off the output signal.

The programmable power supply takes the programmable controller and the microprocessor as the core control circuit; its working principle is as follows: the EMI circuit is used to filter high-frequency harmonics from the external power grid and reduce the electromagnetic interference from power supply itself. The rectifier circuit converts 220V alternating current into direct current. The intermediate direct current link adopts capacitor filtering to reduce the ripple of the direct current voltage and obtain a smooth direct current voltage, which is sent to the inverter circuit. The inverter circuit adopts sinusoidal pulse width modulation (SPWM) control technology to obtain alternating current output, and the harmonic is filtered by the filter circuit to obtain sinusoidal alternating current power, and the magnitude and phase of the output voltage. The sampling circuit obtains feedback signals such as the amplitude and phase of the input power supply, the voltage, current and phase of the output signal. According to the error between the system given signal and the feedback signal, the programmable controller calculates the driving signal required by the inverter circuit, and the driving signal obtains the switching signal for controlling the on-off of the switching tube through the driving circuit to control the operation of the inverter circuit. The protection circuit provides necessary protection measures for the system.

The self-calibration wiring mode of the primary standard current transformer and the secondary standard current transformer is as follows: the primary standard current transformer and the secondary standard current transformer are connected to the output end of the programmable power supply. The output currents of the primary standard current transformer and the secondary standard current transformer can enter the isolated data conversion module through the corresponding current collection circuits. In this case, the isolated data conversion module can not only collect the output voltages of the primary standard current transformer and the secondary standard current transformer, but also collect the voltage signal fed back by the voltage transformer installed at the output end of the programmable power supply. The measurement errors of the primary standard current transformer and the secondary standard current transformer can be obtained through calculation, and the compensation coefficient is obtained in combination with the errors to replace the original coefficient.

### Embodiment 2

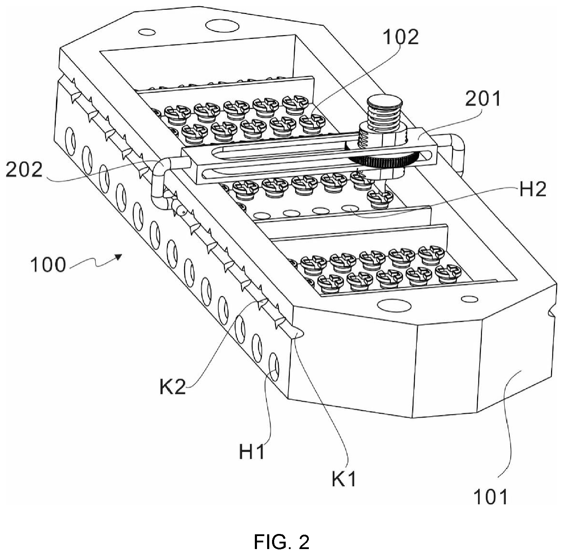

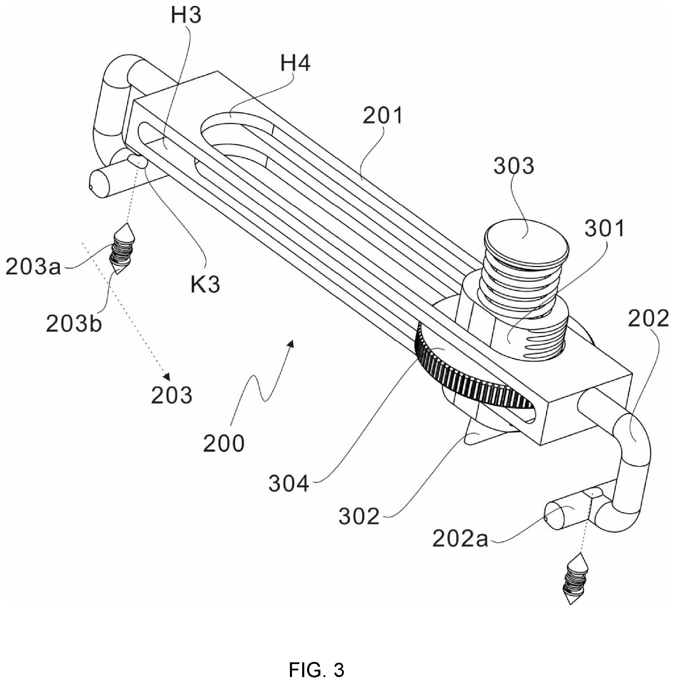

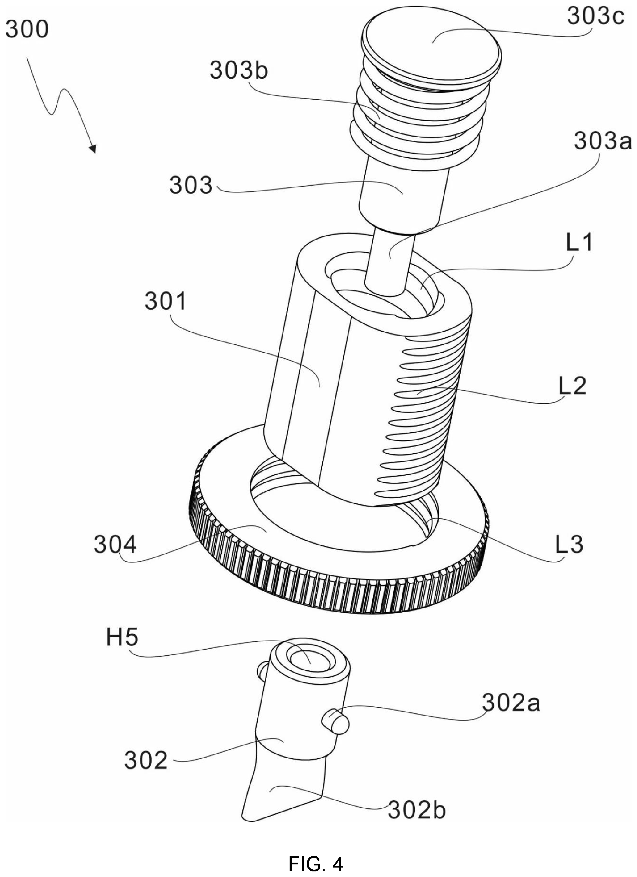

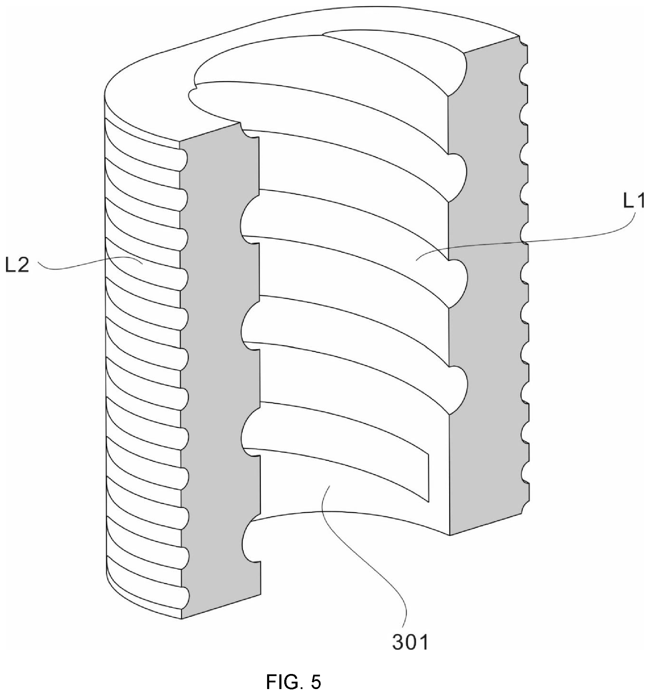

Referring to FIGS. 2 to 5, it is the second embodiment of the present application, which is based on the previous embodiment.

Specifically, the fixed assembly 100 includes a wiring box 101 and a wiring screw 102, and the wiring screw 102 is provided inside the wiring box 101.

The fixed assembly 100 is used to fix the wires to be connected.

The movable assembly 200 is provided at the top of the fixed assembly 100, and includes a translation plate 201, a movable frame 202 and a positioning piece 203; the translation plate 201 is provided at the top of the wiring box 101, the movable frames 202 are provided at both ends of the translation plate 201, and the positioning piece 203 is provided at the ends of the movable frame 202.

The movable assembly 200 is used to position and assist the assembly for tightening the screws.

The adjusting assembly 300 is provided inside the movable assembly 200, and includes an adjustment oblong tube 301, a rotating column 302, a reset column 303 and an anti-tightening ring 304; the adjustment oblong tube 301 passes through and is connected to the translation plate 201, and the rotating column 302 is provided at the bottom of the adjustment oblong tube 301; the reset column 303 is provided at the top of the adjustment oblong tube 301, and the anti-tightening ring 304 is sleeved on the outside the adjustment oblong tube 301.

The adjusting assembly 300 is used to set the optimal pressing position, avoid loose or over-tight pressing, maintain the optimal position, and make each screw reach the optimal position.

Specifically, the wiring box 101 is provided with a wire hole H1 and a screw hole H2; the wire hole H1 is provided at the bottom of the side surface of the wiring box 101, and the screw hole H2 is provided at the top of the wire hole H1 and is communication with the bottom surface of the wiring box 101; the wiring screws 102 is engaged with the screw hole H2.

After the wire is stripped, it is inserted into the wire hole H1, and the wiring screw 102 is screwed into the screw hole H2 to press the wire.

Specifically, the wiring box 101 is further provided with a limiting horizontal groove K1 and a positioning vertical groove K2; the limiting horizontal groove K1 is provided at the top of the side surface of the wiring box 101, the positioning vertical groove K2 is provided above and below the limiting horizontal groove K1, and the positioning vertical groove K2 is directly opposite to the wire hole H1.

The translation plate 201 is used to fix the adjusting assembly 200 and align the adjusting assembly 200 with the wiring screw 102.

Specifically, both sides of the bottom of the translation plate 201 are engaged with the top of the wiring box 101; the translation plate 201 is provided with a limiting horizontal hole H3 and a limiting vertical hole H4; the limiting horizontal hole H3 penetrates through the side surface of the translation plate 201, and the limiting horizontal hole H3 is engaged with the anti-tightening ring 304; the limiting vertical hole H4 penetrates through the upper and lower surfaces of the translation plate 201, and the limiting vertical hole H4 is engaged with the adjustment oblong tube 301.

The cooperation between the movable frame 202 and the limiting column 202a, the positioning piece 203, the limiting horizontal groove K1 and the positioning vertical groove K2 enables the movable assembly 200 to translate along the long end of the wiring box 101 and be stably fixed directly above the screw hole H2, facilitating alignment when tightening the wiring screw 102 without locking the movable assembly 200.

Specifically, the movable frame 202 is a half-frame; one end of the top of the movable frame 202 is fixedly connected to the side surface of the translation plate 201, and one end of the bottom of the movable frame 202 is provided with a limiting column 202a; the limiting column 202a is engaged with the limiting horizontal groove K1; the middle section of the limiting column 202a is provided with a positioning groove K3, and the positioning piece 203 is engaged with the positioning groove K3; the positioning piece 203 is provided with a positioning spring 203a and a positioning cone 203b; one end of the positioning spring 203a is fixed at the bottom of the positioning groove K3, and the other end of the positioning spring 203a is fixed at the bottom of the positioning cone 203b; one end of the positioning cone 203b is engaged with the positioning groove K3, and the other end of the positioning cone 203b is engaged with the positioning vertical groove K2.

When tightening the wiring screw 102, when the positioning cone 203b is engaged with the positioning groove K3, the center line of the movable assembly 200 is aligned directly above the screw hole H2, the force is directed towards the screw hole H2, and the movable assembly 200 will not move; when adjusting the position of the movable assembly 200, the force is directed towards the long end of the wiring box 101, the positioning cone 203b is pushed back into the mounting hole H5, and the movable assembly 200 can translate.

Specifically, the adjustment oblong tube 301 is provided with a double-thread thread L1 and an external thread L2; the double-thread thread L1 is provided inside the adjustment oblong tube 301, the external thread L2 is provided at an outside of the adjustment oblong tube 301, and the adjustment oblong tube 301 is engaged with the limiting vertical hole H4.

The double-thread thread L1 is used to cooperate with the rotating column 302 and prevent the rotating column 302 from being unable to be pushed down due to too dense threads.

The top of the double-thread thread L1 protrudes from the top surface of the adjustment oblong tube 301 for mounting the rotating column 302, and the end of the double-thread thread L1 does not protrude from the bottom surface of the adjustment oblong tube 301 to prevent the rotating column 302 from falling off.

The rotating column 302 is provided with positioning columns 302a, a magnetic head 302b and a mounting hole H5; the positioning columns 302a are symmetrically provided at the side surface of the rotating column 302, and the positioning columns 302a are engaged with the double-thread thread L1; the magnetic head 302b is provided at the bottom of the rotating column 302, the magnetic head 302b is fitted with the wiring screw 102, and the mounting hole H5 is provided at the top of the rotating column 302.

When the rotating column 302 is pressed, the positioning columns 302a move in the double-thread thread L1 until reaching the end of the double-thread thread L1.

Specifically, the reset column 303 is provided with a mounting column 303a, a reset spring 303b and a pressing table 303c; the mounting column 303a is provided at the bottom of the reset column 303, and the mounting column 303a is rotatably connected with the mounting hole H5; the pressing table 303c is provided at the top of the reset column 303, and the reset spring 303b is sleeved on the top of the reset column 303; the top of the reset spring 303b is fixedly connected with the bottom of the pressing table 303c, and the bottom of the reset spring 303b is fixedly connected with the top of the adjustment oblong tube 301; the inner wall of the anti-tightening ring 304 is provided with an internal thread L3, the internal thread L3 is engaged with the external thread L2, and the anti-tightening ring 304 is engaged with the limiting horizontal hole H3.

When the pressing table 303c is subjected to force, it will move towards the wiring box 101 and pushes the rotating column 302 at the same time, so that the rotating column 302 is screwed in along the double-thread thread L1, and the wiring screw 102 adsorbed on the magnetic head 302b is screwed into the screw hole H2.

Rotating the anti-tightening ring 304 adjusts the height of the adjustment oblong tube 301, indirectly adjusting the maximum screwing distance of the magnetic head 302b, so that the wiring screw 102 can be screwed into the optimal position every time.

In use, first the wiring screw 102 is attached onto the magnetic head 302b. Then the movable assembly 200 is adjusted, so that the positioning cone 203b is engaged, and the center line of the movable assembly 200 is aligned with the top of the row of screw holes H2 for tightening the screws. Next, the anti-tightening ring 304 is translated to adjust and position the specific screw hole H2. At this time, the pressing table 303c is pressed down, and the wiring screw 102 is driven into the screw hole H2 by the magnetic head 302b The installation condition of the wiring screw 102 is observed, and the anti-tightening ring 304 is rotated so that the wiring screw 102 is mounted at the optimal position. Once this screw has been properly adjusted, all subsequent screws are mounted at the optimal position, thereby ensuring that all remaining screws can be mounted at the optimal position, greatly reducing the amount of time workers need to mount screws by feel, and reducing the overall installation depth variance, and extending the service life of the wiring box 101.

It should be noted that the above embodiments are only used to illustrate the technical solutions of the present application rather than limit them. Although the present application has been described in detail with reference to the preferred embodiments, those skill in the art should understand that the technical solutions of the present application can be modified or equivalently replaced without departing from the spirit and scope of the technical solutions of the present application, and all such modifications or equivalent replacements shall be covered within the scope of the claims of the present application.

## Claims

1. A live detection system for an in-operation low-voltage current transformer, **characterized by** comprising:
a primary standard current transformer connected to primary current data collection, wherein one end of the primary standard current transformer is connected to a primary current line, and the other end of the primary standard current transformer is located at an interface of a primary current collection circuit;
the primary current collection circuit converting a circuit signal input by the primary standard current transformer into a voltage signal;
a secondary standard current transformer connected to secondary current data collection of a transformer under test, wherein one end of the secondary standard current transformer is connected to a secondary current line of the transformer under test, and the other end of the secondary standard current transformer is connected to an interface of a secondary current collection circuit;
the secondary current collection circuit converting a current signal input by the secondary standard current transformer into a voltage signal;
an isolated data conversion module electrically connected to outputs of the primary current collection circuit and the secondary current collection circuit to isolate and convert an input signal;
a programmable controller electrically connected to the isolated data conversion module and capable of controlling different mode states and data communication of the system; and
a microprocessor configured for performing digital signal processing and analysis, performing error analysis, discrete Fourier transform processing, electric energy conversion for sampled data of different channels, and finally obtaining test results;
wherein an input end of a programmable power supply is connected to a mains power supply, and an output end of the programmable power supply is connected to the primary standard current transformer; a voltage transformer is installed at the output end of the programmable power supply, and after filtering and amplification, is sent to the isolated data conversion module for analog-to-digital (AD) conversion; and a drive protection module of the programmable power supply is electrically connected to the programmable controller.

2. The live detection system for the in-operation low-voltage current transformer according to claim 1, wherein the primary standard current transformer and the secondary standard current transformer comprise three windings: an input winding, an output winding and a feedback winding.

3. The live detection system for the in-operation low-voltage current transformer according to claim 1, wherein the programmable power supply mainly comprises an electromagnetic interference (EMI) circuit, a rectifier circuit, a direct current intermediate circuit, an inverter circuit, a filter circuit, a voltage detection circuit and a drive protection circuit.

4. A wiring connection apparatus, configured to connect the current transformer and the data conversion module according to any one of claims 1 to 3, and the wiring connection apparatus comprising:
a fixed assembly (100) comprising a wiring box (101) and a wiring screw (102), the wiring screw (102) being provided inside the wiring box (101);
a movable assembly (200) provided at a top of the fixed assembly (100), and comprising a translation plate (201), a movable frame (202) and a positioning piece (203); wherein the translation plate (201) is provided at a top of the wiring box (101); the movable frame (202) is provided at both ends of the translation plate (201), and the positioning piece (203) is provided at an end of the movable frame (202); and
an adjusting assembly (300) provided inside the movable assembly (200), and comprising an adjustment oblong tube (301), a rotating column (302), a reset column (303) and an anti-tightening ring (304); wherein the adjustment oblong tube (301) passes through and is connected to the translation plate (201), and the rotating column (302) is provided at a bottom of the adjustment oblong tube (301); the reset column (303) is provided at a top of the adjustment oblong tube (301), and the anti-tightening ring (304) is sleeved on an outside of the adjustment oblong tube (301).

5. The wiring connection apparatus according to claim 4, wherein:
the wiring box (101) is provided with a wire hole (H1) and a screw hole (H2), and the wire hole (H1) is provided at a bottom of a side surface of the wiring box (101); and
the screw hole (H2) is provided at a top of the wire hole (H1) and in communication with a bottom surface of the wiring box (101), and the wiring screw (102) is engaged with the screw hole (H2).

6. The wiring connection apparatus according to claim 5, wherein:
the wiring box (101) is further provided with a limiting horizontal groove (K1) and a positioning vertical groove (K2), and the limiting horizontal groove (K1) is provided at a top of the side surface of the wiring box (101); and
the positioning vertical groove (K2) is provided above and below the limiting horizontal groove (K1), and the positioning vertical groove (K2) is directly opposite to the wire hole (H1).

7. The wiring connection apparatus according to claim 6, wherein:
both sides of a bottom of the translation plate (201) are engaged with the top of the wiring box (101);
the translation plate (201) is provided with a limiting horizontal hole (H3) and a limiting vertical hole (H4);
the limiting horizontal hole (H3) penetrates through a side surface of the translation plate (201), and the limiting horizontal hole (H3) is engaged with the anti-tightening ring (304); and
the limiting vertical hole (H4) penetrates through an upper surface and a lower surface of the translation plate (201), and the limiting vertical hole (H4) is engaged with the adjustment oblong tube (301).

8. The wiring connection apparatus according to claim 7, wherein:
the movable frame (202) is a half-frame; one end of a top of the movable frame (202) is fixedly connected to the side surface of the translation plate (201), and one end of a bottom of the movable frame (202) is provided with a limiting column (202a);
the limiting column (202a) is engaged with the limiting horizontal groove (K1);
a middle section of the limiting column (202a) is provided with a positioning groove (K3), and the positioning piece (203) is engaged with the positioning groove (K3);
the positioning piece (203) is provided with a positioning spring (203a) and a positioning cone (203b); one end of the positioning spring (203a) is fixed at a bottom of the positioning groove (K3), and the other end of the positioning spring (203a) is fixed at a bottom of the positioning cone (203b); and
one end of the positioning cone (203b) is engaged with the positioning groove (K3), and the other end of the positioning cone (203b) is engaged with the positioning vertical groove (K2).

9. The wiring connection apparatus according to claim 8, wherein:
the adjustment oblong tube (301) is provided with a double-thread thread (L1) and an external thread (L2); the double-thread thread (L1) is provided inside the adjustment oblong tube (301); the external thread (L2) is provided at an outside of the adjustment oblong tube (301), and the adjustment oblong tube (301) is engaged with the limiting vertical hole (H4); and
the rotating column (302) is provided with positioning columns (302a), a magnetic head (302b) and a mounting hole (H5); the positioning columns (302a) are symmetrically provided at a side surface of the rotating column (302), and the positioning columns (302a) are engaged with the double-thread thread (L1); the magnetic head (302b) is provided at a bottom of the rotating column (302); the magnetic head (302b) is fitted with the wiring screw (102), and the mounting hole (H5) is provided at a top of the rotating column (302).

10. The wiring connection apparatus according to claim 9, wherein:
the reset column (303) is provided with a mounting column (303a), a reset spring (303b) and a pressing table (303c);
the mounting column (303a) is provided at a bottom of the reset column (303), and the mounting column (303a) is rotatably connected with the mounting hole (H5);
the pressing table (303c) is provided at a top of the reset column (303), and the reset spring (303b) is sleeved on the top of the reset column (303);
a top of the reset spring (303b) is fixedly connected to a bottom of the pressing table (303c), and a bottom of the reset spring (303b) is fixedly connected to a top of the adjustment oblong tube (301); and
an inner wall of the anti-tightening ring (304) is provided with an internal thread (L3); the internal thread (L3) is engaged with the external thread (L2), and the anti-tightening ring (304) is fitted with the limiting horizontal hole (H3).
